# EUROPEAN PATENT SPECIFICATION

(11) **EP 0 409 384 B1**
(45) Date of publication and mention of the grant of the patent: **15.11.1995**
(21) Application number: 90305418.7
(22) Date of filing: 18.05.1990
(51) Int. Cl.: H03K 17/12, H02M 7/17

(54) **Method and apparatus for achieving current balance in parallel connected switching devices**
Verfahren und Gerät zum Erreichen einer gleichförmigen Stromverteilung in parallel angeordneten Schaltvorrichtungen
Procédé et appareil pour réaliser l'équilibre des courants dans des dispositifs de commutation branchés en parallèle

(30) Priority: 20.07.1989 US 382942
(43) Date of publication of application: 23.01.1991
(73) Proprietor: GENERAL ELECTRIC COMPANY, Schenectady, NY 12345 (US)
(72) Inventor: Lezan, Georges Robert Eugene, Roanoke, Virginia 24153 (US); Walker, Loren Haines, Salem, Virgina 24153 (US)
(74) Representative: Szary, Anne Catherine, Dr.

(56) References cited:
- EP-A- 0 288 421
- GB-A- 2 082 002
- Soviet Inventions Illustrated, section El, week 8706, 25 March 1987, Derwent Publications LTD., London, GB, class X, p.20, No. 87-042277/06.
- IEE PROC. vol. 129 B, no. 4, July 1982, pages 199 - 204; D. W. AUCKLAND ET AL.: 'Control method for compensation of switching delays in transistors. '

## Description

This invention was made with Government support under prime contract number DNA001-88-C-0028 (subcontract 19399-TSA-2) awarded by the Department of Defense. The Government has certain rights in this invention. The foregoing relates to the US Government.

The present invention relates generally to switching systems and more particularly to a method and apparatus for minimizing current imbalance in a plurality of switching devices connected in parallel between two electrical power sources and adapted to transfer electrical power between the two sources.

There are a number of applications where, because of current ratings, two or more switching devices are connected in parallel and configured to be simultaneously conductive to transfer electrical power between a source and a load, the latter in certain applications also representing a source during certain phases of circuit operation. When the switching devices are of the non-proportional, semiconductor type [especially thyristors including thyristors of the gate turn-off (GTO) type], it is desired to maintain, to the degree practical, current balance between the several devices of the plurality combination. Balance within the several devices permits utilizing devices in applications closer to their individual ratings since the devices must, at least, be sized for worst case normal conditions.

Current imbalance within parallel connected switching devices can result from a number of factors. Primarily among these factors, which will be discussed in more detail later, are (a) differences in turn-on time between the devices, (b) differences in the inductance of the bus associated with the devices, (c) differences in the bus resistance, and (d) differences in the forward voltage drop of the devices.

One known scheme for minimizing current imbalance in these situations employs large iron core magnetic elements. This results in space requirements, electrical losses and additional expense.

Another scheme for minimizing current imbalance is known from document SOVIET INVENTIONS ILLUSTRATED, section El, week 8706, 25 March 1987, Derwent Publications LTD., London, class X, page 20, No. 87-042277/06, SU-A-1 239 789: Regulated delay lines are used in parallel thyristor converter arms. Sensors monitor average currents in each arm. When an unbalance is detected a signal is generated delaying thyristor firing in the excessively loaded branch.

There is disclosed herein an improved power switching system employing a plurality of parallel connected switch devices in which current imbalance is minimized. More particularly it incorporates an improved scheme for tending to maintain current balance within parallel connected semiconductor switching devices connected between two electrical power sources.

With such parallel connected switching devices constituted by thyristors configured to be simultaneously conductive, current balance is maintained by varying the turn-on time of the individual thyristors based upon the relative values of the current during the previous conduction period, without requiring inclusion of large iron cored magnetic elements.

In accordance with one aspect of the present invention, in a power switching system which employs a plurality of switching devices connected in parallel between two power sources, the devices are configured to be simultaneously conductive and are rendered individually conducting in response to the application of respective control signals. Current balance is maintained within the several switching devices by a scheme which provides for the development of individual current signals, respectively representing the current magnitude within the individual devices. There is also developed an average current signal which represents the average of all the individual currents within a plurality. A difference signal, derived as a function of any difference between the individual signal and the average signal is provided for each of the devices and, based upon that difference signal at a first conducting period, the time of rendering conductive the switching device associated with that difference signal is varied for the next conduction period.

While the present invention is defined in the appended claims, a better understanding of it can be had from the following description taken in conjunction with the accompanying drawings in which:
Fig. 1 is an schematic diagram illustrating a typical power switching environment incorporating the present invention;
Fig. 2 is a schematic diagram illustrating a portion of the bridge circuit of Fig. 1 in greater detail and useful in understanding the present invention;
Figs. 3 through 8 are graphical representations illustrating various circuit relationships and useful in understanding the present invention;
Fig. 9 is a schematic diagram illustrating a portion of Fig. 2 and further illustrating the derivation of certain signals employed in the present invention;
Fig. 10 is a block diagram illustrating an implementation of the present invention in a first preferred embodiment;
Fig. 10A illustrates an implementation of the timer included in Fig. 10;
Fig. 11 is a series of traces drawn to the same time base and useful in understanding the operation of the Fig. 10 implementation, while Figs. 11A and 11B are traces relating to the operation of the timer;
Fig. 12 is a block diagram illustrating the present invention in a second preferred embodiment;
Fig. 13 is a block diagram illustrating the present invention in a third preferred embodiment; and,
Fig. 14 is a series of traces drawn to the same time base and useful in understanding the Fig. 13 implementation.
Fig. 15 is a block diagram illustrating the application of the invention concept to a system having three paralleled switching devices;

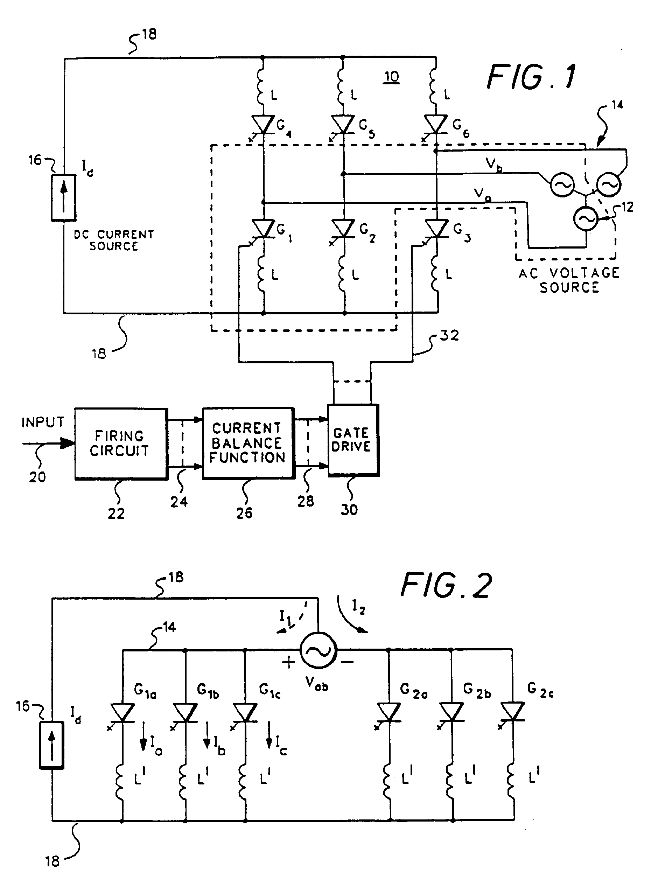

Reference is now made to Fig. 1 which illustrates a typical scheme for use with and including the current balance function of the present invention. For purposes of illustration, an array of switching devices is disposed in a three phase bridge 10 comprised of six switching devices, shown as gate turn-off thyristors (GTOs) labeled G₁-G₆. (As earlier indicated, the present invention is generally applicable to non-proportional devices. Because of the particularly characteristics of the GTO, they have been used for purpose of illustration. Thus, while the following description will often be couched in terms of the GTO, the invention is not to be considered as limited thereby.) Included in series with each of the GTOs, G₁-G₆, is a series inductance L. The junction point of each pair of series connected GTOs (e.g. G₁ and G₄) is connected via a bus 14 to an first power source shown as AC voltage source 12, illustrated as a three phase source connected in a wye configuration. A second power source shown as DC current source 16 is connected by way of the two lines of a DC bus 18 to the bridge 10 all in a manner well known in the art. The DC current source 16 provides a current I_{d} which will exist variously within the GTOs, G₁-G₆. It should be noted that while element 16 is indicated as a DC current source in accordance with the true designation of the present invention, in a more conventional sense, element 16 may be considered as a load such as a large inductance to be supplied by the bridge 10. However, because of its inductive nature, during periods of commutation of devices G₁-G₆, element 16 will act as a current source.

Control of the switching devices or GTOs, G₁-G₆, is the result of an input signal on line 20. This signal is only generically pertinent to the present invention and may emanate from any suitable source such as an operator control of automatic or manual nature. The function of the input on line 20 is simply to govern to the overall level of system operation. The input on line 20 is provided to a firing circuit 22 which generates a series of pulses, provided on lines 24, generally designating the time at which the plurality of the devices of the bridge 10 are to be fired (i.e., rendered conductive). In accordance with the present invention, this timing function is affected or modified by the current balance function 26 which is central to the present invention as will be described. The output of the current balance function 26, via lines 28, is applied to gate drivers 30 which form the actual gate pulses to be supplied to the devices of the bridge 10 via lines 32, only two of which are illustrated. With the exception of the included current balance function 26, the total depiction of Fig. 1 is that which is understood by those familiar with the art.

Fig. 2 is an expansion on that portion of Fig. 1 shown within the dash line block plus the inclusion of the DC current source 16 and the DC bus 18. As is known, when the current requirements exceed that of a single switching device, a plurality of such devices having, as near as possible, identical characteristics may be connected in parallel. This is shown in Fig. 2 wherein three GTOs, G₁ₐ and G_{1b} are depicted and collectively represent GTO G₁ of Fig. 1. Similarly GTOs, G₂ₐ, G_{2b} and G_{2c}, represent the GTO G₂ in Fig. 1. (It is also recognized that it is common practice, when the voltage requirements exceed the capabilities of a single device such as G₁ₐ, to provide a series arrangement of devices and thus, each of the GTOs in the Fig. 2 depiction can represent a series arrangement of substantially identical GTOs.) The GTOs here included are connected to the V_{ab} portion of the AC voltage source. An inductor L′ is connected in series with each of the GTOs. Typically each of the inductors L′ will have approximately three times value of inductance as that of L in Fig. 1. It is, of course, realized that the three GTO showing is arbitrarily and that a lesser number (2) or a greater number could be employed with equal facility.

Looking now to the operation of the Fig. 2 depiction, it will be assumed that a DC current I_{d} from the source 16 exists (labeled I₂) in that basic leg comprised of the GTOs, G₂ₐ, G_{2b}, and G_{2c}, and that it is desired to commutate that current to the other basic leg represented by the three GTOs, G₁ₐ, G_{1b}, and G_{1c}. This intended commutation is illustrated by the dash line depiction labeled I₁. Once this commutation is complete, the respective GTOs will have individual currents Iₐ, I_{b}, and I_{c} which in sum will equal current I_{d}. Maintaining the balance of these individual currents within the three parallel GTOs is the function of the present invention.

As earlier indicated, the basic factors which may contribute to imbalance (differences) in the currents Iₐ, I_{b}, and I_{c} are differences in turn-on time, differences in the forward drop cross the semiconductor, differences in bus inductance and differences in bus resistance. The following analysis applies to a set of any number of semiconductors in parallel. Three have been selected for purposes of illustration. It is also assumed, in the following discussion that the GTOs will conduct for 120 electrical degrees.

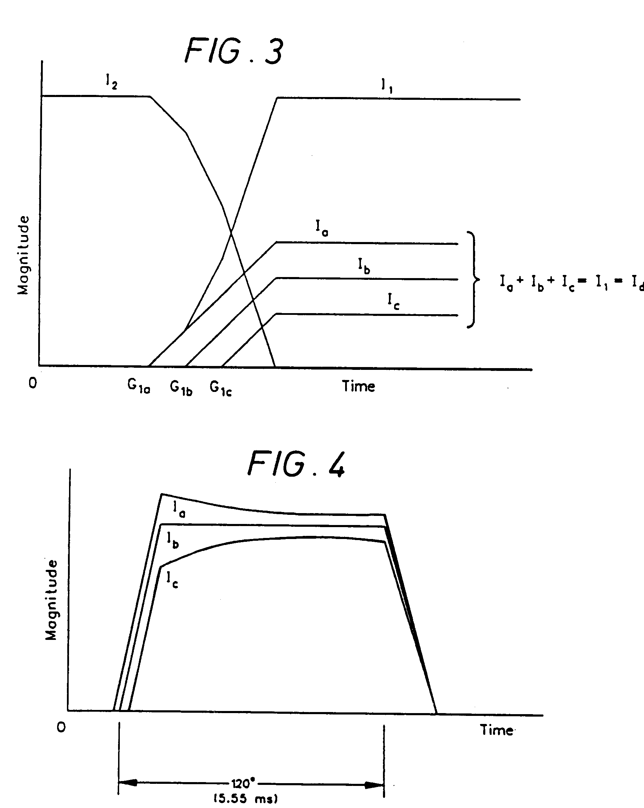

It is known that if one semiconductor of a parallel connected set has a shorter turn-on time than the others of the set, it is likely to pre-establish a current in itself which will tend to cause its steady state current to be higher than that of the others. This is illustrated in Fig. 3 in which it is assumed that the three semiconductors all have different turn-on times. Fig. 3, which plots the current magnitude as a function of time, shows that GTO G₁ₐ turns on first. Thus current I₂ starts to diminish while I₁ tends to increase. When GTOs, G_{1b} and G_{1c} turn on, there are faster decreases in I₂ and more rapid increases in I₁. When the GTOs G₁ₐ, G_{1b} and G_{1c}are fully conductive, the sum of their currents, I₁, will equal the original current 1_{d}. The time period which is illustrated in Fig. 3 might, as an example in a 60 Hertz system, extend for approximately 100 microseconds.

Fig. 4 which extends, basically, through 120 electrical degrees (5.55 milliseconds in a 60 Hertz system) shows what happens next. The imbalance in currents, established by the turn-on time differences, will tend to redistribute among the GTOs if there is no other cause of imbalance. The degree to which the redistribution occurs is a function of the time constant of the circuits including the inductance and resistance of the various branches. As a typical example the value of inductor L′ may be selected to limit the change in current to some value such as 100 amperes per microsecond. If the voltage V_{ab} is 3000 volts, then L′ must be about 15 microhenrys. The resistance of the GTO and inductor may be about 1.1 milliohms. This gives a time constant of L/R = 13.6 milliseconds. Since this is about 2.5 times the 5.6 millisecond conduction period, the L/R time constant will not permit full equalization in the 120 electrical degree period. Typically the decay is about forty percent (40%) of the initial imbalance. Thus, under the present situation, there will exist at the end of the anticipated 120 degree conduction period a current imbalance resulting from differences in turn-on time.

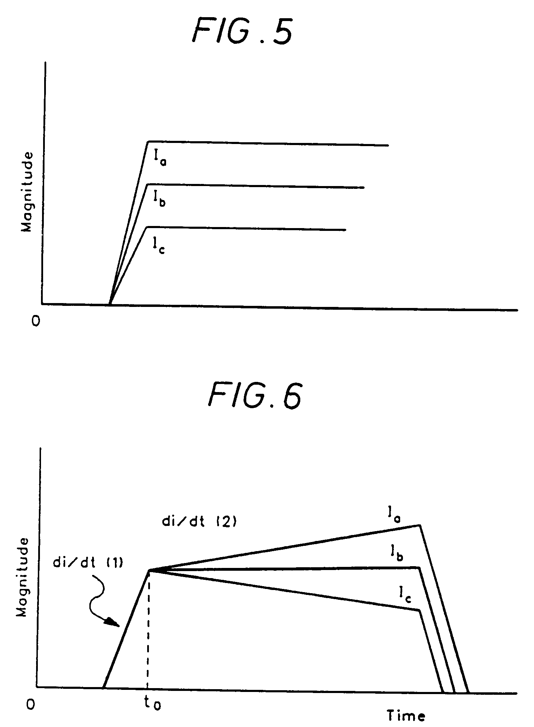

Differences in bus inductance, which may result from the bus itself and/or variations in the individual inductances L′ will also have an effect on the currents which are established in each GTO. This effect is similar to that caused by differences in the turn-on time. This is illustrated in Fig. 5 where it is seen that, although each GTO is represented as turning on at the same time, the respective currents Iₐ, I_{b}, and I_{c} have a different rate of increase and rise to different levels.

Fig. 6 illustrates the current differences which may occur if the forward voltage drops across the several GTOs differ. The depiction in Fig. 6 assumes that the GTOs have identical turn-on times and thus the currents are all started identically as illustrated by the forward slope labeled di/dt (1). Once the rise is over, time tₒ, the currents begin to diverge depending upon the differences in forward voltage drop. The rates at which these currents diverge are dependent upon the value of these differences in forward drop. As indicated by the three currents Iₐ, I_{b}, and I_{c}, after time tₒ, device G_{1c} has the greatest forward voltage drop (or highest path resistance) while device G₁ₐ has the lowest voltage drop (or lowest path resistance). A similar result will exist in a case of differences in resistance of the paths associated with each of the GTOs. This has not been separately illustrated.

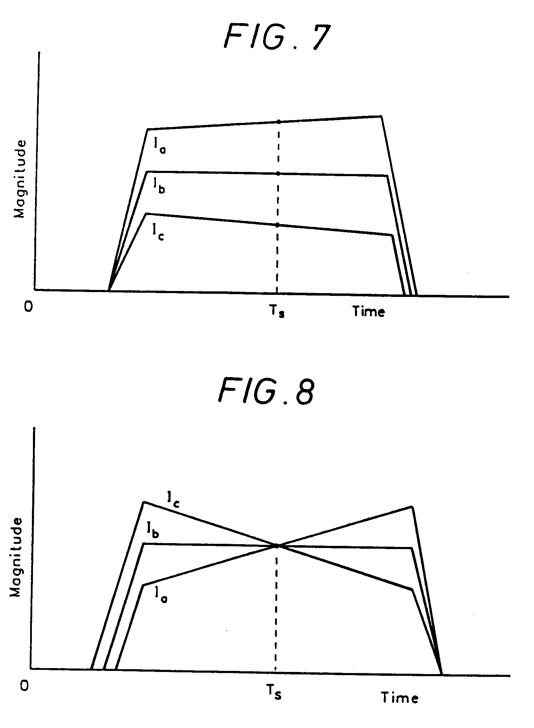

The approach to be taken to correct an imbalance in the currents in the GTOs, regardless of the cause(s), is to take advantage of the first feature discussed above; that is, to take advantage of the feature that the GTO which turns on first will sustain a higher current. Use will also be made of the effect that current change after turn on proceeds at a moderate rate; i.e., the current imbalance established at turn-on will to some extent continue to the end of the 120 degree conduction period. Based upon these premises, the effect of the current balance scheme in accordance with the present invention is shown in Figs. 7 and 8.

Fig. 7 illustrates a typical current cycle (120 degrees) with varying current imbalances. The depiction of Figs. 7 and 8 assumes that it is desired to maintain an average current balance over the 120 degree conduction period. Thus, a sampling which will be more fully explained later is performed at the middle of the period, at time Tₛ. At this time, the currents in each of the GTOs under consideration will be sampled (Fig. 7) and the next time this particular set of GTOs is gated on, those GTOs whose current was greater than the average will be gated later than those with an average value, while those GTOs whose currents are smaller than the average will be gated on earlier than those with average value. This process continues with each cycle of the particular GTOs in question to make the current values the same at time Tₛ such that the integrated values of the currents are the same as shown in Fig. 8. The slopes of the currents remain more-or-less the same, because these slopes are functions of forward drop and/or resistance and are not adjustable, but they have been exaggerated in Fig. 8 for clarity. As indicated, selecting the sampling time Tₛ in the middle of the conduction period tends to balance the average of the currents over the period. If for some reason it is desired to balance at other times such as to have current balance at turn-off or to allow more current to the cell with the low forward drop to balance losses rather than current, the sampling time can be adjusted accordingly. A late sampling time balances the turn-off current while early sampling time tends to balance cell losses by giving the low forward drop cell a chance to pick up current after time Tₛ.

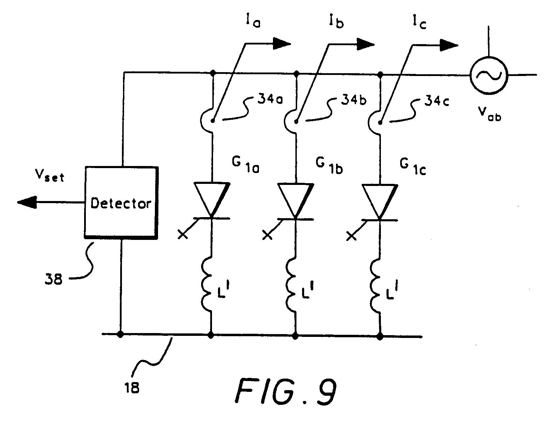

Implementation of the present invention requires signals representing the currents in each of the semiconductors of the set. Fig. 9 shows suitable current sensing means 34ₐ, 34_{b} and 34_{c} provided in series with each of the semiconductors of the set (G₁ₐ, G_{1b}, G_{1c}) to provide signals representing currents Iₐ, I_{b} and I_{c}. The sensing devices may be of any suitable type such as current transformers or more accurate devices which will also sense a DC component of a current, such as a "LEM" module, may be used. A "LEM" module is a device employing a Hall Effect crystal and is commercially provided by LIAISONS ÉLECTRONIQUES MÉCANIQUES of Geneve, Switzerland.

The embodiment of the invention to be described also employs a signal termed Vₛₑₜ which represents the voltage across the set of GTOs prior to conduction. In Fig. 9, Vₛₑₜ is the output of a suitable voltage detector 38 connected between the DC bus and the AC bus associated with a set of GTOs. This bus to bus connection is possible since the critical use time of Vₛₑₜ is when there is no current in the GTO. One could, of course, sense the voltage directly across the GTO.

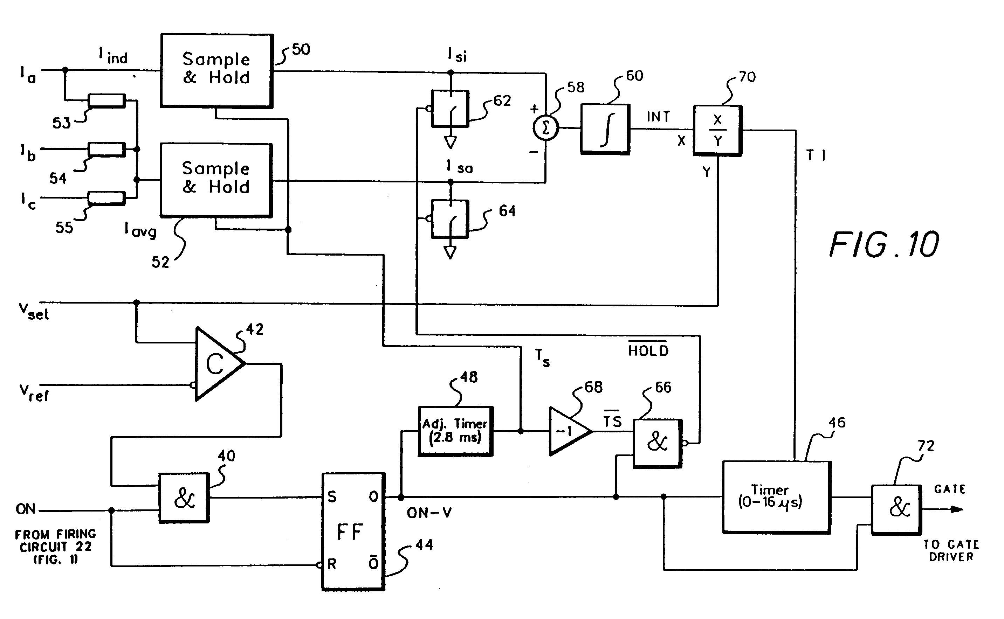

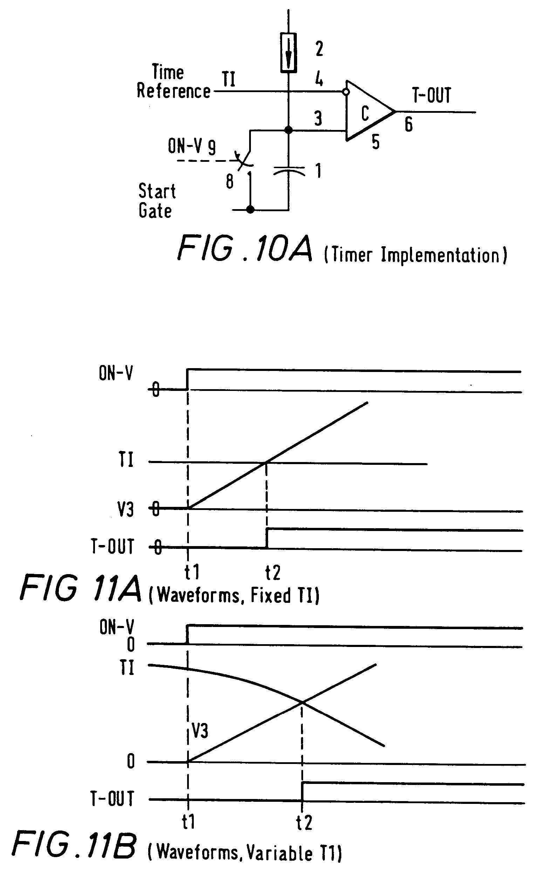

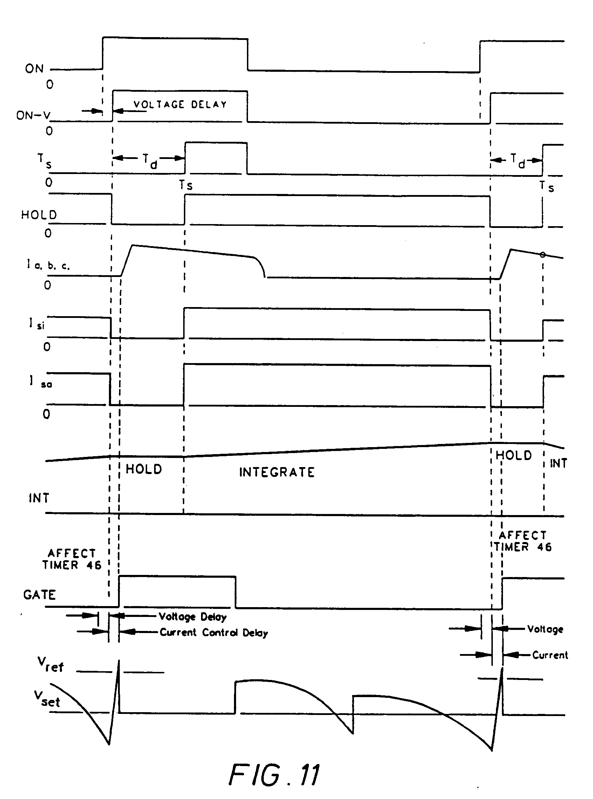

The current balance function 26 of Fig. 1, and of the present invention is illustrated in its first embodiment in Fig. 10. Referencing now that figure, a signal ON from the firing circuit 22 (Fig. 1) serves as one input to an AND gate 40 the other input of which is the output of a comparator 42. Comparator 42 receives two inputs, the Vₛₑₜ signal, and a V_{ref} signal such that the output of the comparator 42 will be high only when Vₛₑₜ exceeds V_{ref}. In a typical application employing GTOs the V_{ref} signal would represent a value of 500 volts. The output of AND gate 40 serves as the set input to a flip-flop 44 which has the ON signal applied to an inverting reset terminal R. Thus, flip-flop 44 will provide an output signal ON-V at its Q output terminal so long as the ON signal exists starting with the time that Vₛₑₜ exceeds V_{ref}. The ON-V signal forms a starting input to a timer 46 to be discussed in greater detail later. The ON-V signal also supplied to an adjustable timer 48 whose output is the time of sampling signal Tₛ. In the example being described the Tₛ signal occurs at the mid-point of the 120 degree conduction period. Thus, as parenthetically shown, the Tₛ signal occurs approximately 2.8 milliseconds after the occurrence of the ON-V signal. The Tₛ signal is first applied to a pair of sample and hold circuits 50 and 52. Sample and hold circuit 50 has applied to it a one of the individual GTO current signals, in this case signal Iₐ. The three signals Iₐ, I_{b}, and I_{c} are averaged by an averaging circuit comprised of resistors 53, 54 and 55 and that average (I_{avg}) is applied to the second sample and hold circuit 52. The output of sample and hold circuit 52 (Iₛₐ) is provided as the negative input to a summing junction 58 whose output is the input to an integrator 60. The other (positive) input to junction 58 is the output of the sample and hold circuit 50 (designated Iₛᵢ). The two currents Iₛᵢ and Iₛₐ may be shunted to ground by way of two switches, respectively 62 and 64, which are under the control of a signal H̅O̅L̅D̅. The H̅O̅L̅D̅ signal is the output of an AND gate 66 the inputs of which are the ON-V signal and the output of an inverter 68 whose input is the Tₛ signal. Thus, the outputs of the sample and hold circuits 50 and 52 will be held at zero to prevent the integrator 60 from changing its output until the appropriate sampling time Tₛ.

The output of integrator 60 is applied as the x input to x/y divider 70. The y input is the Vₛₑₜ signal. The output of that divider, signal TI, is applied to the timer 46 to adjust the timing thereof. The output of the timer 46 is applied to an gate 72, the second input of which is the ON-V signal. The output of gate 72 is applied to the gate driver 30 (Fig. 1) as the gating signal for the individual GTO being served, in this case G₁ₐ.

Continuing with the present example for a 60 Hertz system, assume that the ON-V signal is generated 8 microseconds before the desired turn-on time for the appropriate GTO, and that the timer 46 provides an 8 microsecond delay for a "normal" value of TI input (indicating no difference in the individual and average current values). If the total range of timer 46 is from 0 to 16 microseconds, the individual GTO may be gated, in accordance with the present example, any time from 8 microseconds before to 8 microseconds after the normal gating time. These are only representative values arbitrarily selected to a particular system. Other values could, of course, be used.

The initial function of the Vₛₑₜ signal was to assure that the proper GTO forward voltage was available before the gate timing delay starts. The second function of Vₛₑₜ is as the y input to the x/y divider 70. Since Vₛₑₜ represents a voltage across the parallel set of GTOs, its magnitude at the instant of turn-on of the GTOs determines the rate of current change (di/dt) of the respective currents. Thus, to make a given current correction, the time needed by timer 46 is inversely proportional to Vₛₑₜ. By applying Vₛₑₜ to the divider 70, time difference resulting from the TI signal is also made an inverse function of the Vₛₑₜ value.

The operation of the circuitry of Fig. 10 is better understood with reference to the several traces of Fig. 11, which are drawn to the same time scale. As shown by the bottom trace, the GTO voltage Vₛₑₜ is reversed at the instant of commutation. The utilization of the ON signal, shown at the top of the sheet, is delayed until the Vₛₑₜ signal reaches some value, for example 500 volts, represented by V_{ref}. The second trace, ON-V, shows this delay. Timer 48 is initiated by the ON-V signal and generates the Tₛ signal delayed by the time T_{d} typically 60 electrical degrees or in a case of a 60 Hertz system 2.8 milliseconds. The Tₛ signal activates the sample and hold circuits 50 and 52 to lock in the respective values of I_{ind} and I_{avg}. In the traces this is illustrated by the traces labelled I_{a, b, c}, Iₛᵢ and Iₛₐ. It should be noted that until this time the switches 62 and 64 have been closed and these two switches now open because of the change in state of the output of AND gate 66. Thus, the two signals from the sample and hold circuits are furnished as the positive and negative inputs to summing junction 58 whose output is applied to integrator 60 which integrates the difference between the individual current and the average current signals from time Tₛ until the GTO is next gated on.

Below the trace designated INT (the output of the integrator 60) in Fig. 11, two points are marked "Affect Timer 46". Once the integrator has had its affect on the turn-on time it holds its value (switches 62 and 64 close) until the next current sampling. with a proper gain in the integrator there will be no error in current in the next cycle. The change in gating time generated by the signal sample should correct the current errors unless the operating point changes. If an error remains the integrator will continue to move until current balance is achieved.

Figure 10A shows an exemplary implementation of a timer to serve the function shown as 46 in Fig. 10. Figs. 11A and 11B show representative waveforms illustrating the operation of the timer.

The timer is formed of current source 2, capacitor 1, switch 8, and comparator 5. It is controlled by Time Reference TI and Start Gate ON-V. In operation, switch 10 is initially closed. When Start Gate ON-V goes high, switch 8 opens. The current source 12 charges the capacitor 1 generating a ramp voltage of fixed rate of change of voltage at point 3. Comparator 5 compares the voltage across the capacitor to the reference TI on conductor 4. when the voltage V3 on point 3 is more positive than that on point 4, the comparator generates a positive output on terminal 6 designated T-OUT.

Fig. 11A shows the waveforms for the case in which Time Reference TI is a constant voltage during the period of timing. ON-V goes positive at time t1. The voltage at 3 begins to rise. At time t2 the voltage V3 exceeds voltage TI and the output of comparator 5 switches high, generating output TOUT. The time delay generated is t2-t1.

Figure 11B shows a case in which the Time Reference TI is variable. The operation is similar, but the time delay generated depends only on the value of TI at the instant t2 when the timer completes its timing.

In the current balance control provided by the Fig. 10 embodiment, two modes of timer operation occur, corresponding to Figs. 11A and 11B. In either case the signal TI which controls the timer 46 is provided by the divider 70. The input INT to divider 70 is a constant during the operation of the timer because the integrator input 58 is subject to the HOLD signal as soon as ON-v goes positive. The second input to the divider 70 is Vₛₑₜ. This voltage is constant during the operation of the timer 46 in the first case and is rising rapidly during this time in the second case.

The first case or mode occurs when in the power circuit, the voltage Vₛₑₜ is positive and greater than V_{ref} at the time the ON signal occurs. In this case the positive voltage is provided by the sinusoidal AC voltage supply to the power circuit. This voltage changes very slowly with respect to the 16 microsecond time of the timer 46 and can be regarded as constant during that period. This case is represented by Figure 11A. The operation is proper in that the forward voltage across the power semiconductors (which is provided by the AC source) controls the delay time introduced for current balance purposes. This mode of operation is that of a conventional phase controlled thyristor circuit, and is not further discussed in this application.

A more complex mode is introduced when the power semiconductors are GTOs. GTOs can turn off when the voltage and current imposed on them are still positive. This implies that the subsequently conducting GTO must be able to turn on while the voltage across it is negative. Since even GTOs cannot turn on without forward voltage, the operation of the power circuit is as follows: when the presently conducting GTO turns off at such a time in the AC wave that the voltage across the GTO next to be gated would be negative, the next GTO cannot conduct, and the DC current source has no GTO path in which to flow. The only path provided for the DC current source during this transient time is the capacitive snubber customarily connected across each GTO. This snubber (not shown) typically consists of a capacitor in series with a parallel combination of a resistor and a diode poled in the same sense as the GTO. The voltage across this capacitor rises rapidly and linearly in the direction to apply forward voltage across the GTO. When this voltage (Vₛₑₜ) exceeds V_{ref} (as shown in Figure 10), then the turn-on delays are initiated. In this case the voltage Vₛₑₜ continues to rise relatively rapidly while the time delay 46 is operating. This rise of voltage on Vₛₑₜ causes a fall of voltage TI at the output of divider 70. Thus, this case corresponds to the waveforms of Fig. 11B The timing is determined by the final voltage Vₛₑₜ existing at the instant the timer delay is completed. This is the same as the instant of GTO firing. Since the current balancing action in the power circuit is determined by the instantaneous voltage across the GTO and its reactor at the instant of turn-on, the timer is responsive to the proper value of voltage.

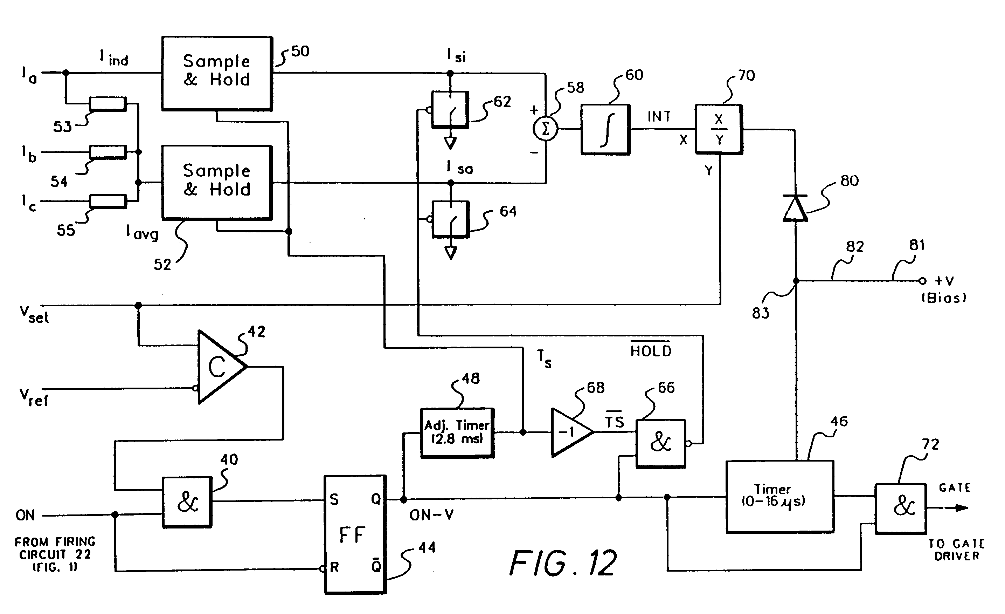

Fig. 12 illustrates a second embodiment of this present invention and it is readily apparent that the implementation as shown in Fig. 12 is very similar to that of Fig. 10. The primary difference in function with this circuit is that, whereas the earlier embodiment allowed the gate signal to be shifted in time in both directions, the embodiment in Fig. 12 permits only delay from the "normal" or standard time. In this case, the circuit difference resides at the output of the divider 70 which is applied to a rectifier 80 which passes only negative voltage. The output of that rectifier 80 is applied to node 83 which receives a +V signal from terminal 81 via line 82. In this instance the bias is sufficient to provide an 8 microsecond delay in timer 46. As such, if there is no error and no output from the integrator, the delay will be 8 microseconds which, as previously, represents the normal gating time of the GTO. If there is an error indicating a need for delay, then the negative value out of integrator 60 will exceed that of the bias on terminal 81 and result in greater than an 8 microsecond delay. It is, of course, apparent that the bias signal could be eliminated in the Fig. 33 implementation by providing the ON signal at the "normal" time and adjusting the timer to provide, for example, a zero to 8 microseconds delay.

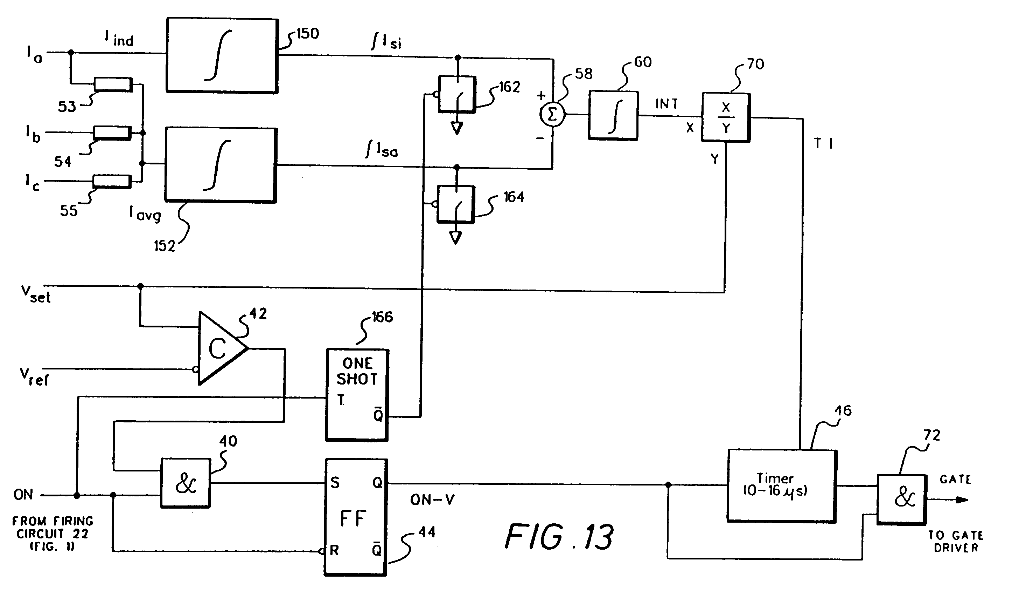

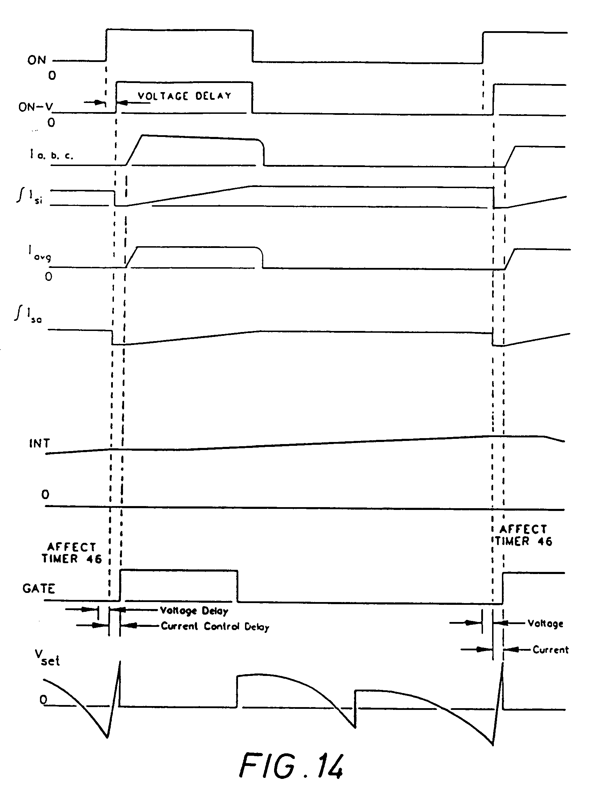

Fig. 13, which is best understood taken with the waveforms of Fig. 14, illustrates another preferred embodiment of the present invention. In Fig. 13 the sample and hold circuits 50 and 52 of the earlier embodiments are replaced, respectively, by integrators 150 and 152. The outputs of the two integrators are respectively, the integrated values of the individual and average currents; i.e., ∫Iₛᵢ and ∫Iₛₐ. The former value forms the positive input to a summing junction 58 while the latter value forms the negative input to junction 58.

The integrators 150 and 152 may be periodically reset, as illustrated by the switches 162 and 164 which, when closed, connect the two integrated values to ground. Switches 162 and 164 are operated in response to the Q̅ output of a monostable multivibrator or "one shot" 166 which receives at its trigger input the ON signal from the firing circuit 22 (Fig. 1). One shot 166 develops a very narrow pulse (for example, 5 microseconds) at the beginning of each conduction period to close switches 162 and 164 and reset the integrators 150 and 152.

In this embodiment, as is better understood with reference to the traces of Fig. 14 , it is the function of integrators 150 and 152 to measure current values during the extant conduction period and, by way of summing junction 58, to provide to integrator 60 any difference in the values ∫Iₛᵢ and ∫Iₛₐ during this period.

The function of integrator 60, whose output is the signal INT, is to remember past errors in current and combine those cumulative past errors with any presently determined error to provide correction for subsequent conduction periods.

It is noted that this embodiment does not employ timer 48, inverter 68 and gate 66 included in the Fig. 10 embodiment. It is also to be noted this embodiment could be utilized in the embodiment of Fig. 12.

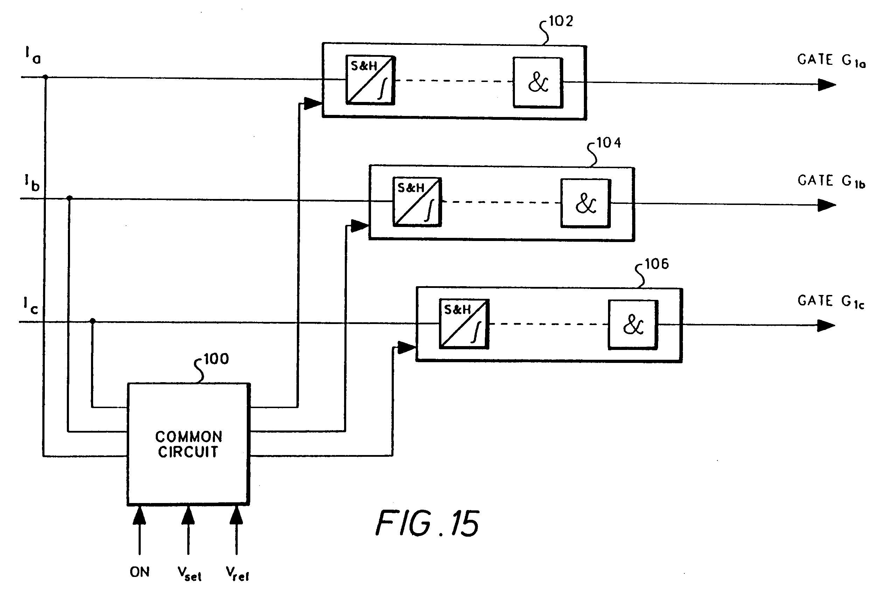

In each of the embodiments much of the circuitry serves the entire array of GTOs within the plurality or the parallel set. All functions dealing with the voltage and average current are central to the array. Thus, the only functions which are duplicated on an individual GTO (switching device) basis are, in Fig. 10, the sample and hold circuit associated with the individual (i.e., sample and hold 50 in the illustrated embodiment) switch 62, integrator 60, divider 70, timer 46, and gate 72. The rest of the functions serve the entire array. In the Fig. 12 embodiment, rectifier 80 and bias circuit have been added while in Fig. 13 the sample and hold circuit is replaced by integrator 150. This concept is illustrated in Fig. 15 which shows a common circuit 100 and three individual circuits 102, 104 and 106 each including a sample and hold circuit (e.g. circuit 50) or integrator (150) and extending to an AND gate (e.g. gate 72).

While the present invention has been described in its preferred embodiments, the modifications thereto will readily occur to those skilled in the art. The applicability to switching devices other than GTOs has been previously mentioned as has the fact that the concepts are applicable to parallel arrays of lesser or greater numbers than the illustrated three. It has also been noted that the single switching device in each parallel leg could be replaced by plural devices in series. It is to be specifically recognized that although analog implementations, which are better able to give an understanding of the invention, have been illustrated, digital equivalents (using, for example, counters for the integrating functions, etc.) are clearly considered to be within the scope of the invention as claimed. It is also recognized that, while an AC voltage source and a DC current source have been selected for purposes of illustration, the nature of the sources is not critical to the invention. That is, both sources could be either AC or DC or the current source could be AC with a DC voltage source.

## Claims

1. A method of controlling a plurality of switching devices connected in parallel between two electrical power sources in a power switching system, said devices configured to be simultaneously conductive and being rendered individually conductive in response to the application of respective control signals and being controlled toward maintaining current balance within said switching devices, said method comprising the steps:
a) generating individual current signals respectively representative of the current magnitude within each switching device;
b) generating an average current signal representing the average current within said plurality;
c) generating a difference signal as a function of the difference between a one of said individual current signals and said average current signal; and,
d) selectively adjusting the time of application of a next control signal to the switching device associated with the one of said individual current signals with respect to the time of application of next control signals to the remaining switches of said plurality as a function of said difference signal.

2. The method in accordance with Claim 1 wherein said steps of generating a difference signal and adjusting of time are performed separately for each of the devices of said plurality.

3. The method in accordance with Claim 1 wherein the step of generating a difference signal involves the steps of:
a) combining the one of said individual current signals and said average current signal at a prescribed point in time to develop an error signal; and,
b) integrating said error signal to achieve said difference signal.

4. The method in accordance with Claim 3 wherein said prescribed point in time is defined by delaying a predetermined period after the nominal turn-on time of said plurality.

5. The method in accordance with Claim 3 wherein said prescribed point in time is defined by;
a) determining that a forward voltage across said plurality exceeds a predetermined minimum and;
b) delaying a predetermined period after the determining step.

6. The method in accordance with Claim 1 wherein:
a) in response to a difference signal of substantial zero magnitude the next control signal is applied to the associated one of said devices at a first point in time;
b) in response to a difference signal indicating a larger than average current the next control signal is applied to the associated one of said devices at a point in time delayed from said first point in time; and,
c) in response to a difference signal indicating a smaller than average current the next control signal is applied at a point in time advanced from said first point in time.

7. The method in accordance with Claim 6 wherein the amounts of said delay and advance in time are proportional to the magnitude of said difference signal.

8. The method in accordance with Claim 1 wherein only difference signals representing a larger than average current value are recognized and wherein said step of adjusting is effective only to individual ones of said devices associated with such difference signals and serves to delay in time the application of the next control signal from a normal time of applying said control signal.

9. The method in accordance with Claim 8 wherein the amount of delay in time is proportional to the value of said difference signal.

10. The method in accordance with Claim 1 wherein the step of generating a difference signal comprises:
a) integrating said one of said individual current signals during a conduction period to provide a first integrated current signal;
b) integrating said average current signal during the same conduction period to provide a second integrated current signal; and
c) combining said first and second integrated current signals to generate an error signal for said conductive period; and
d) respectively integrating the error signal developed on successive conductive periods for said plurality to generate said difference signal

11. The method in accordance with Claim 10 wherein said steps of generating a difference signal and adjusting of time are performed separately for each of the devices of said plurality.

12. The method in accordance with anyone of Claims 1,3,4,5 or 10, further including the steps of:
a) providing a voltage signal proportional to the forward voltage across said plurality; and,
b) modifying the effect of said difference signal as a function of said voltage signal.

13. A switching arrangement for transferring electrical power between two electrical power sources, said switching arrangement comprising:
a) at least one plurality of switching devices connected in parallel and disposed between said power sources for controlling the power transferred therebetween, said devices configured to be simultaneously conductive and being individually rendered conductive in response to the application thereto of individual control signals;
b) means to provide individual current signals representing the respective currents in each of the devices of said plurality;
c) means to provide an average current signal representing the average value of said individual current signals;
d) means to develop a difference signal as a function of the difference between an individual current signal and the average current signal;
e) means to generate a control signal operative to render conductive an associated one of said devices; and,
f) means responsive to said difference signal to vary the time, with respect to a predetermined norm, of application of said control signal to the associated one of said devices whereby differences in current value within said devices are reduced.

14. The switching arrangement in accordance with Claim 13 wherein said devices are thyristors.

15. The switching arrangement in accordance with Claim 14 wherein said thyristors are the gate turn-off type.

16. The switching arrangement in accordance with Claim 13 including means for developing a difference signal with respect to each of the individual current signals and means responsive to said difference signals for respectively developing control signals for each of said switching devices.

17. The switching arrangement in accordance with Claim 13 wherein said means to develop the difference signal includes:
a) means to combine a one of said individual current signals and said average current signal to develop an error signal; and,
b) means to integrate said error signal to provide said difference signal

18. The switching arrangement in accordance with Claim 17 further including timing means responsive to said difference signal to adjust the time of providing said control signal.

19. The switching arrangement in accordance with Claim 16 further including timing means responsive to each of said difference output signals to adjust, respectively in response thereto, the time of application of said control signals.

20. The switching arrangement in accordance with Claim 19 wherein said timing means adjusts the timing of said control signals in a manner to selectively lead or lag an uncorrected time of developing said control signals.

21. The switching arrangement in accordance with Claim 19 wherein said timing means provides a delay in providing said control signals with respect to an uncorrected time of developing said control signal.

22. The switching arrangement in accordance with Claim 13 wherein said means for developing a difference signal includes delay means for determining the time of developing said difference signal.

23. The switching arrangement in accordance with Claim 22 wherein said delay means is adjustable.

24. The switching arrangement in accordance with Claim 22 wherein said delay means includes a timer and a sample and hold circuit for each of said individual current signals and said average current signal.

25. The switching arrangement in accordance with Claim 24 wherein said delay means is adjustable to provide an output to determine the time of applying the content of said sample and hold circuits.

26. The switching arrangement in accordance with Claim 24 further including means to generate a voltage signal representative of the voltage across said plurality of switching devices prior to their becoming conductive and means to prevent the initiation of the operation of said delay means until said voltage signal reaches a predetermined magnitude.

27. The switching arrangement in accordance with Claim 18 further including means to generate a voltage signal representative of the voltage across said plurality of switching devices prior to their becoming conductive and gain means responsive to said voltage signal to vary the value of said difference prior to the application thereof to said timing means.

28. The switching arrangement in accordance with Claim 13 wherein said means to develop a difference signal comprises:
a) first integrating means responsive to the individual current signal during a conductive period to provide a first integrated current signal;
b) second integrating means responsive to said average current signal during said conductive period to provide a second integrated current signal;
c) means to combine said first and second integrated signals to develop an error signal as a function of a difference therebetween; and
d) means to integrate said error signal during successive conductive periods of said plurality to develop said difference signal.

29. The switching arrangement in accordance with Claim 28 including means for developing a difference signal with respect to each of the individual current signals and means responsive to said difference signals for respectively developing control signals for each of said switching devices.

## Patentansprüche

1. Verfahren zum Steuern einer Anzahl von Schaltvorrichtungen, die zwischen zwei elektrischen Stromquellen in einem Leistungsschaltsystem parallel geschaltet sind, wobei die Vorrichtungen so konfiguriert sind, daß sie gleichzeitig leitend sind und einzeln leitend gemacht werden als Antwort auf das Anlegen von entsprechenden Steuersignalen, und gesteuert sind zur Aufrechterhaltung eines Stromgleichgewichtes unter den Schaltvorrichtungen, wobei das Verfahren die Schritte enthält:
a) Erzeugen einzelner Stromsignale, die auf entsprechende Weise die Stromgröße innerhalb jeder Schaltvorrichtung darstellen,
b) Erzeugen eines mittleren Stromsignals, das den mittleren Strom in der Anzahl darstellt,
c) Erzeugen eines Differenzsignals als eine Funktion der Differenz zwischen einem der einzelnen Stromsignale und dem mittleren Stromsignal, und
d) selektives Einstellen der Anlegungszeit eines nächsten Steuersignals an die Schaltvorrichtung, die einem der einzelnen Stromsignale zugeordnet ist, in bezug auf die Anlegungszeit von nächsten Steuersignalen an die übrigen Schalter der Anzahl als eine Funktion des Differenzsignals.

2. Verfahren nach Anspruch 1, wobei die Schritte zum Erzeugen eines Differenzsignals und zum Einstellen der Zeit getrennt für jede der Vorrichtungen der Anzahl ausgeführt werden.

3. Verfahren nach Anspruch 1, wobei der Schritt zum Erzeugen eines Differenzsignals die Schritte enthält:
a) Verknüpfen von einem der einzelnen Stromsignale und des mittleren Stromsignals zu einem vorgeschriebenen Zeitpunkt, um ein Fehlersignal zu entwickeln, und
b) Integrieren des Fehlersignals, um das Differenzsignal zu erzielen.

4. Verfahren nach Anspruch 3, wobei der vorgeschriebene Zeitpunkt durch Verzögern einer vorbestimmten Periode nach der nominalen Einschaltzeit der Anzahl definiert wird.

5. Verfahren nach Anspruch 3, wobei der vorgeschriebene Zeitpunkt definiert wird durch:
a) Ermitteln, daß eine Vorwärtsspannung über der Anzahl ein vorbestimmtes Minimum überschreitet, und
b) Verzögern um eine vorbestimmte Periode nach dem Ermittlungsschritt.

6. Verfahren nach Anspruch 1, wobei:
a) als Antwort auf ein Differenzsignal mit im wesentlichen der Größe Null das nächste Steuersignal an die zugeordnete der Vorrichtungen zu einem ersten Zeitpunkt angelegt wird,
b) als Antwort auf ein Differenzsignal, das einen größeren als den mittleren Strom angibt, das nächste Steuersignal an die zugeordnete der Vorrichtungen zu einem Zeitpunkt angelegt wird, der gegenüber dem ersten Zeitpunkt verzögert ist, und
c) als Antwort auf ein Differenzsignal, das einen kleineren als den mittleren Strom angibt, das nächste Steuersignal zu einem Zeitpunkt angelegt wird, der von dem ersten Zeitpunkt vorverschoben ist.

7. Verfahren nach Anspruch 6, wobei die Größen der zeitlichen Verzögerung und der zeitlichen Vorverschiebung proportional zur Größe des Differenzsignals sind.

8. Verfahren nach Anspruch 1, wobei nur Differenzsignale, die einen größeren als den mittleren Stromwert darstellen, erkannt werden und der Einstellschritt nur an einzelnen der Vorrichtungen wirksam wird, die diesen Differenzsignalen zugeordnet sind, und dazu dient, das Anlegen des nächsten Steuersignals von einer normalen Zeit zum Anlegen des Steuersignals zeitlich zu verzögern.

9. Verfahren nach Anspruch 8, wobei die Größe der zeitlichen Verzögerung proportional zum Wert des Differenzsignals ist.

10. Verfahren nach Anspruch 1, wobei der Schritt zum Erzeugen eines Differenzsignals enthält:
a) Integrieren von einem der einzelnen Stromsignale während einer Leitungsperiode, um ein erstes integriertes Stromsignal zu liefern,
b) Integrieren des mittleren Stromsignals während der gleichen Leitungsperiode, um ein zweites integriertes Stromsignal zu liefern, und
c) Verknüpfen der ersten und zweiten integrierten Stromsignale, um ein Fehlersignal für die Leitungsperiode zu erzeugen, und
d) entsprechendes Integrieren des Fehlersignals, das in aufeinanderfolgenden Leitungsperioden für die Anzahl entwickelt wird, um das Differenzsignal zu erzeugen.

11. Verfahren nach Anspruch 10, wobei die Schritte zum Erzeugen eines Differenzsignals und zum Einstellen der Zeit getrennt für jede der Vorrichtungen der Anzahl ausgeführt werden.

12. Verfahren nach einem der Ansprüche 1, 3, 4, 5 oder 10, enthaltend die Schritte:
a) Liefern eines Spannungssignals proportional zu der Vorwärtsspannung über der Anzahl und
b) Modifizieren der Wirkung des Differenzsignals als eine Funktion des Spannungssignals.

13. Schaltanordnung zum Übertragen elektrischer Energie zwischen zwei elektrischen Stromquellen, wobei die Schaltanordnung enthält:
a) wenigstens eine Anzahl von Schaltvorrichtungen, die parallel geschaltet und zwischen den Stromquellen angeordnet sind, zum Steuern der dazwischen übertragenen Energie, wobei die Vorrichtungen so konfiguriert sind, daß sie gleichzeitig leitend sind und einzeln leitend gemacht werden als Antwort auf das Anlegen von einzelnen Steuersignalen,
b) eine Einrichtung zum Liefern einzelner Stromsignale, die die entsprechenden Ströme in jeder der Vorrichtungen der Anzahl darstellen,
c) eine Einrichtung zum Liefern eines mittleren Stromsignals, das den mittleren Wert der einzelnen Stromsignale darstellt,
d) eine Einrichtung zum Entwickeln eines Differenzsignals als eine Funktion der Differenz zwischen einem einzelnen Stromsignal und dem mittleren Stromsignal,
e) eine Einrichtung zum Erzeugen eines Steuersignals, das die Wirkung hat, zugeordnete Vorrichtungen leitend zu machen, und
f) eine Einrichtung, die auf das Differenzsignal anspricht, um die Zeit in bezug auf eine vorbestimmte Norm des Anlegens des Steuersignals an die zugeordnete der Vorrichtungen zu verändern, wodurch Differenzen in dem Stromwert unter den Vorrichtungen verkleinert werden.

14. Schaltanordnung nach Anspruch 13, wobei die Vorrichtungen Thyristoren sind.

15. Schaltanordnung nach Anspruch 14, wobei die Thyristoren Abschalt- bzw. Gate-Turn-Off-Thyristoren sind.

16. Schaltanordnung nach Anspruch 13, enthaltend eine Einrichtung zum Entwickeln eines Differenzsignals in bezug auf jedes der einzelnen Stromsignale und eine Einrichtung, die auf die Differenzsignale anspricht, zum entsprechenden Entwickeln von Steuersignalen für jede der Schaltvorrichtungen.

17. Schaltanordnung nach Anspruch 13, wobei die Einrichtung zum Entwickeln des Differenzsignals enthält:
a) eine Einrichtung zum Verknüpfen von einem der einzelnen Stromsignale und des mittleren Stromsignals, um ein Fehlersignal zu entwickeln, und
b) eine Einrichtung zum Integrieren des Fehlersignals, um das Differenzsignal zu liefern.

18. Schaltanordnung nach Anspruch 17, ferner eine Zeitsteuereinrichtung enthaltend, die auf das Differenzsignal anspricht, um die Zeit zum Liefern des Steuersignals einzustellen.

19. Schaltanordnung nach Anspruch 16, ferner eine Zeitsteuereinrichtung enthaltend, die auf jedes der Differenzausgangssignale anspricht, um auf entsprechende Weise als Antwort darauf die Zeit des Anlegens der Steuersignale einzustellen.

20. Schaltanordnung nach Anspruch 19, wobei die Zeitsteuereinrichtung die Zeitsteuerung der Steuersignale in einer Weise einstellt, um einer unkorrigierten Zeit des Entwickeln der Steuersignale selektiv vor- oder nachzueilen.

21. Schaltungsanordnung nach Anspruch 19, wobei die Zeitsteuereinrichtung eine Verzögerung liefert bei der Ausbildung der Steuersignale in bezug auf eine unkorrigierte Zeit des Entwickelns des Steuersignals.

22. Schaltanordnung nach Anspruch 13, wobei die Einrichtung zum Entwickeln eines Differenzsignals eine Verzögerungseinrichtung aufweist zum Bestimmen der Zeit des Entwickelns des Differenzsignals.

23. Schaltanordnung nach Anspruch 22, wobei die Verzögerungseinrichtung einstellbar ist.

24. Schaltanordnung nach Anspruch 22, wobei die Verzögerungseinrichtung eine Zeitsteuerung und eine Abtast- und -Halteschaltung für jedes der einzelnen Stromsignale und des mittleren Stromsignals aufweist.

25. Schaltanordnung nach Anspruch 24, wobei die Verzögerungseinrichtung einstellbar ist, um eine Ausgangsgröße zu liefern, um die Zeit des Anlegens des Inhaltes der Abtast- und -halteschaltungen zu bestimmen.

26. Schaltanordnung nach Anspruch 24, ferner eine Einrichtung enthaltend, um ein Spannungssignal zu erzeugen, das die Spannung über den mehreren Schaltvorrichtungen darzustellt, bevor diese leitend werden, und eine Einrichtung, um den Betriebsbeginn der Verzögerungseinrichtung zu verhindern, bis das Spannungssignal eine vorbestimmte Größe erreicht.

27. Schaltanordnung nach Anspruch 18, ferner eine Einrichtung enthaltend, um ein Spannungssignal zu erzeugen, das die Spannung über der Anzahl von Schaltvorrichtungen darstellt, bevor diese leitend werden, und eine Verstärkungseinrichtung, die auf das Spannungssignal anspricht, um den Wert der Differenz vor ihrem Anlegen an die Zeitsteuereinrichtung zu verändern.

28. Schaltanordnung nach Anspruch 13, wobei die Einrichtung zum Entwickeln eines Differenzsignals enthält:
a) eine erste Integriereinrichtung, die auf das einzelne Stromsignal während einer Leitfähigkeitsperiode anspricht, um ein erstes integriertes Stromsignal zu liefern,
b) eine zweite Integriereinrichtung, die auf das mittlere Stromsignal während der Leitfähigkeitsperiode anspricht, um ein zweites integriertes Stromsignal zu liefern,
c) eine Einrichtung zum Verknüpfen der ersten und zweiten integrierten Signale, um ein Fehlersignal als eine Funktion von einer Differenz dazwischen zu entwickeln, und
d) eine Einrichtung zum Integrieren des Fehlersignals während aufeinanderfolgender Leitfähigkeitsperioden der Anzahl, um das Differenzsignal zu entwickeln.

29. Schaltanordnung nach Anspruch 28, enthaltend eine Einrichtung zum Entwickeln eines Differenzsignals in bezug auf jedes der einzelnen Stromsignale und eine auf die Differenzsignale ansprechende Einrichtung zum entsprechenden Entwickeln von Steuersignalen für jede der Schaltvorrichtungen.

## Revendications

1. Procédé de commande d'une pluralité de dispositifs de commutation connectés en parallèle entre deux sources d'énergie électrique dans un système de commutation d'énergie électrique, lesdits dispositifs étant configurés de manière à être simultanément conducteurs et étant rendus individuellement conducteurs en réponse à l'application de signaux de commande respectifs et étant commandés de manière à tendre à maintenir un équilibre de courant à l'intérieur desdits dispositifs de commutation, ledit procédé comprenant les étapes:
(a) de génération de signaux de courant individuels représentant respectivement l'amplitude de courant à l'intérieur de chaque dispositif de commutation;
(b) de génération d'un signal de courant moyen représentant le courant moyen à l'intérieur de ladite pluralité;
(c) de génération d'un signal de différence en fonction de la différence entre un premier desdits signaux de courant individuels et ledit signal de courant moyen; et,
(d) de réglage, de façon sélective, du temps d'application d'un signal de commande suivant au dispositif de commutation associé au premier desdits signaux de courant individuel en ce qui concerne le temps d'application des signaux de commande suivants aux commutateurs restants de la dite pluralité en fonction dudit signal de différence.

2. Procédé selon la revendication 1, dans lequel lesdites étapes de génération d'un signal de différence et de réglage de temps sont exécutées séparément pour chacun des dispositifs de ladite pluralité.

3. Procédé selon la revendication 1, dans lequel l'étape de génération d'un signal de différence met en jeu les étapes:
(a) de combinaison du premier desdits signaux de courant individuels et dudit signal de courant moyen à un instant prescrit pour développer un signal d'erreur; et,
(b) d'intégration dudit signal d'erreur pour obtenir ledit signal de différence.

4. Procédé selon la revendication 3, dans lequel ledit instant prescrit est défini par une temporisation d'une durée prédéterminée après le temps nominal de passage à l'état conducteur de ladite pluralité.

5. Procédé selon la revendication 3, dans lequel ledit instant prescrit est défini par:
(a) détermination du fait qu'une tension directe aux bornes de ladite pluralité dépasse un minimum prédéterminé; et
(b) temporisation d'une durée prédéterminée après l'étape de détermination.

6. Procédé selon la revendication 1, dans lequel:
(a) en réponse à un signal de différence d'une amplitude sensensiblement nulle, le signal de commande suivant est appliqué à celui associé desdits dispositifs à un premier instant;
(b) en réponse à un signal de différence indiquant un courant plus grand que le courant moyen, le signal de commande suivant est appliqué à celui associé desdits dispositifs à un instant en retard par rapport au premier instant; et,
(c) en réponse à un signal de différence indiquant un courant plus petit que le courant moyen, le signal de commande suivant est appliqué à un instant en avance par rapport audit premier instant.

7. Procédé selon la revendication 6, dans lequel les durées dudit retard et de ladite avance sont proportionnelles à l'amplitude dudit signal de différence.

8. Procédé selon la revendication 1, dans lequel seuls les signaux de différence représentant une valeur de courant moyen plus grande que la valeur de courant moyen sont identifiés et dans lequel ladite étape de réglage n'est effective que pour ceux individuels desdits dispositifs qui sont associés à de tels signaux de différence et sert à retarder l'application du signal de commande suivant par rapport à l'instant normal d'application dudit signal de commande.

9. Procédé selon la revendication 8, dans lequel la durée du retard est proportionnelle à la valeur dudit signal de différence.

10. Procédé selon la revendication 1, dans lequel l'étape de génération d'un signal de différence comprend:
(a) une intégration dudit premier des signaux courant individuels pendant une période de conduction de manière à obtenir un premier signal de courant intégré;
(b) une intégration dudit signal de courant moyen pendant la même période de conduction de manière à obtenir un second signal de courant intégré; et
(c) une combinaison desdits premier et second signaux de courant intégrés pour générer un signal d'erreur pendant ladite période de conduction; et
(d) une intégration, respectivement, du signal d'erreur élaboré sur des périodes de conduction successives pour que ladite pluralité génère ledit signal de différence.

11. Procédé selon la revendication 10, dans lequel lesdites étapes de génération de signal de différence et de réglage de temps sont exécutés séparément pour chacun des dispositifs de ladite pluralité.

12. Procédé selon l'une quelconque des revendications 1, 3, 4, 5 ou 10, comprenant les étapes:
(a) d'obtention d'un signal de tension proportionnel à la tension directe aux bornes de ladite pluralité; et,
(b) de modification de l'effet dudit signal de différence en fonction dudit signal de tension.

13. Agencement de commutation pour transférer de l'énergie électrique entre deux sources d'énergie électrique, ledit agencement de commutation comprenant:
(a) au moins une pluralité de dispositifs de commutation connectés en parallèle et disposés entre lesdites sources d'énergie électrique pour commander l'énergie transférée entre ces dernières, lesdits dispositifs étant configurés de manière à être simultanément conducteurs et étant rendus individuellement conducteurs en réponse à l'application de signaux de commande individuels à ces dispositifs;
(b) un moyen pour fournir des signaux de courant individuels représentant les courants respectifs dans chacun des dispositifs de ladite pluralité;
(c) un moyen pour fournir un signal de courant moyen représentant la valeur moyenne desdits signaux de courant individuels;
(d) un moyen pour élaborer un signal de différence en fonction de la différence entre un signal de courant individuel et le signal de courant moyen;
(e) un moyen pour générer un signal de commande agissant de manière à rendre conducteur celui associé desdits dispositifs; et,
(f) un moyen réagissant audit signal de différence en modifiant le temps, par rapport à une norme prédéterminée, d'application dudit signal de commande à celui associé desdits dispositifs, grâce à quoi les différences de valeur de courant dans lesdits dispositifs se trouvent réduites.

14. Agencement de commutation selon la revendication 13, dans lequel lesdits dispositifs sont des thyristors.

15. Agencement de commutation dans lequel lesdits thyristors sont du type blocable.

16. Agencement de commutation selon la revendication 13, comprenant un moyen pour élaborer un signal de différence par rapport à chacun des signaux de courant individuels et un moyen réagissant auxdits signaux de différence en élaborant respectivement des signaux de commande pour chacun desdits dispositifs de commutation.

17. Agencement de commutation selon la revendication 13, dans lequel ledit moyen pour élaborer un signal de différence comprend:
(a) un moyen pour combiner un premier desdits signaux de courant individuels et ledit signal de courant moyen afin d'élaborer un signal d'erreur; et,
(b) un moyen pour intégrer ledit signal d'erreur afin de fournir ledit signal de différence.

18. Agencement de commutation selon la revendication 17, comprenant, en outre, un moyen de synchronisation réagissant audit signal de différence en réglant le temps pendant lequel ledit signal de commande est fourni.

19. Agencement selon la revendication 16, comprenant, en outre, un moyen de synchronisation réagissant à chacun des signaux de sortie de différence en réglant, respectivement in réponse à ces derniers, le temps d'application desdits signaux de commande.

20. Agencement de commutation selon la revendication 19, dans lequel ledit moyen de synchronisation règle la cadence desdits signaux de commande de manière qu'ils soient sélectivement en avance ou en retard sur un temps non corrigé d'élaboration desdits signaux de commande.

21. Agencement de commutation selon la revendication 19, dans lequel le moyen de synchronisation effectue une temporisation en produisant lesdits signaux de commande par rapport à un temps non corrigé d'élaboration dudit signal de commande.

22. Agencement de commutation selon la revendication 13, dans lequel le moyen pour élaborer un signal de différence comprend un moyen de temporisation pour déterminer le temps d'élaboration dudit signal de différence.

23. Agencement de commutation selon la revendication 22, dans lequel ledit moyen de temporisation est réglable.

24. Agencement de commutation selon la revendication 22, dans lequel ledit moyen de temporisation comprend un circuit de chronodéclenchement et un circuit d'échantillonnage et de blocage pour chacun desdits signaux de courant individuels et ledit signal de courant moyen.

25. Agencement de commutation selon la revendication 24, dans lequel le moyen de temporisation peut être réglé de manière à fournir une sortie pour déterminer le temps d'application du contenu des circuits d'échantillonnage et de blocage.

26. Agencement de commutation selon la revendication 24, comprenant, en outre, un moyen pour générer un signal de tension représentant la tension aux bornes de ladite pluralité de dispositifs de commutation avant qu'ils ne deviennent conducteurs et un moyen réagissant audit signal de tension en modifiant la valeur de ladite différence avant leur application audit moyen de synchronisation.

27. Agencement de commutation selon la revendication 18, comprenant, en outre, un moyen pour générer un signal de tension représentatif de la tension aux bornes de ladite pluralité de dispositifs de commutation avant qu'ils ne deviennent conducteurs et un moyen d'amplification réagissant audit signal de tension en modifiant la valeur de ladite différence avant son application audit moyen de synchronisation.

28. Agencement de commutation selon la revendication 13, dans lequel ledit moyen pour élaborer un signal de différence comprend;
(a) un premier moyen d'intégration réagissant au signal de courant individuel pendant une période de conduction en fournissant un premier signal de courant intégré;
(b) un second moyen d'intégration réagissant audit signal de courant moyen pendant ladite période de conduction en fournissant un second signal de courant intégré;
(c) un moyen pour combiner lesdits premier et second signaux intégrés de manière à élaborer un signal d'erreur en fonction d'une différence entre ces premier et second signaux; et
(d) un moyen pour intégrer ledit signal d'erreur pendant des périodes de conduction successives de ladite pluralité pour élaborer ledit signal de différence .

29. Agencement de commutation selon la revendication 28, comprenant un moyen pour élaborer un signal de différence par rapport à chacun des signaux de courant individuels et un moyen réagissant auxdits signaux de différence en élaborant respectivement des signaux de commande pour chacun desdits dispositifs de commutation.
